# EUROPEAN PATENT APPLICATION

(11) **EP 4 554 333 A1**
(43) Date of publication of application: **14.05.2025**
(21) Application number: 22950216.6
(22) Date of filing: 06.07.2022
(51) Int. Cl.: H05H 1/26

(54) **PLASMA HEAD AND PLASMA GENERATION DEVICE**

(71) Applicant: Fuji Corporation, Chiryu-shi, Aichi 472-8686 (JP)
(72) Inventor: SANO Hiroki, Chiryu-shi, Aichi 472-8686 (JP); IKEDO Toshiyuki, Chiryu-shi, Aichi 472-8686 (JP); IWATA Takuya, Chiryu-shi, Aichi 472-8686 (JP)
(74) Representative: Grünecker Patent- und Rechtsanwälte PartG mbB
(86) International application number: PCT/JP2022/026806
(87) International publication number: WO 2024/009422

(57) **Abstract**

A plasma head includes a cylindrical main body configured to conduct a process gas to be converted into plasma; a pair of electrodes accommodated in the main body and configured to discharge a part of the process gas to generate a plasma gas; and a flow rectifying member having multiple flow rectifying plates configured to make the process gas introduced into the main body and supplied to the pair of electrodes form a spiral flow.

## Description

### Technical Field

The present description relates to a plasma head and a plasma generation device.

### Background Art

Conventionally, for example, a plasma head and a plasma generation device (hereinafter, referred to as "conventional device or the like") disclosed in Patent Literatures 1 and 2 are known. In the conventional device or the like, a process gas (for example, nitrogen gas, air containing nitrogen gas, or the like) passes through an opening portion and is supplied to the inside. The opening portion has a hole through which the process gas passes, and the hole is provided to be inclined obliquely. Thus, the process gas that has passed through the opening portion flows spirally between an outer electrode and an inner electrode.

### Citation List

### Patent Literature

Patent Literature 1:JP-A-2009-202087
Patent Literature 2:JP-A-2010-132469

### Summary of the Invention

### Technical Problem

The opening portion provided in the above-described conventional device or the like has a hole drilled in a circular plate to be inclined with respect to an axis of the circular plate. Therefore, in the conventional device or the like, the process gas supplied from an upstream side needs to pass through the hole, and a large reduction loss occurs in the process gas passing through the hole having a small flow path cross-sectional area. Therefore, in the conventional device or the like, there is a possibility that a flow velocity of the process gas decreases on a downstream side of the opening portion, that is, between the outer electrode and the inner electrode, and as a result, a flow velocity required for a process is not obtained even in a plasma gas applied to a workpiece. Accordingly, in the plasma head and the plasma generation device, it is desirable to reduce the reduction loss of the process gas supplied to the electrode in a spiral flow.

An object of the present description is to provide a plasma head and a plasma generation device capable of reducing a reduction loss of a process gas supplied between electrodes by a spiral flow.

### Solution to Problem

The present description discloses a plasma head including a cylindrical main body configured to conduct a process gas to be converted into plasma; a pair of electrodes accommodated in the main body and configured to discharge a part of the process gas to generate a plasma gas; and a flow rectifying member having multiple flow rectifying plates configured to make the process gas introduced into the main body and supplied to the pair of electrodes form a spiral flow.

The present description also discloses a technical idea in which the "plasma head according to claim 2 or 3" is changed to the "plasma head according to any one of claims 2 to 4" in claim 5 at the beginning of the application. Further, the present description discloses a technical idea in which the "plasma head according to any one of claims 1 to 3" is changed to the "plasma head according to any one of claims 1 to 7" in claim 8 at the beginning of the application. Further, the present description discloses a technical idea in which the "plasma head according to any one of claims 1 to 3" is changed to the "plasma head according to any one of claims 1 to 8" in claim 9 at the beginning of the application.

According to this, since the process gas passes through the flow rectifying member having the flow rectifying plate, the plasma head can reduce the reduction loss generated in the process gas supplied to the electrode as the spiral flow.

### Brief Description of Drawings

Fig. 1 is a schematic view illustrating an overall configuration of a plasma generation device.
Fig. 2 is a partial cross-sectional view illustrating a configuration of a plasma head.
Fig. 3 is a perspective view illustrating a flow rectifying member provided in the plasma head of Fig. 2.
Fig. 4 is a top view of the flow rectifying member of Fig. 2.
Fig. 5 is a bottom view of the flow rectifying member of Fig. 2.
Fig. 6 is a perspective view illustrating a flow rectifying plate and a first circular ring of the flow rectifying member.
Fig. 7 is a diagram illustrating a disposition of the flow rectifying plate.
Fig. 8 is a perspective view illustrating a second circular ring of the flow rectifying member.
Fig. 9 is a perspective view illustrating a flow rectifying member according to a first modified example.
Fig. 10 is a top view of the flow rectifying member of Fig. 9.
Fig. 11 is a bottom view of the flow rectifying member of Fig. 9.
Fig. 12 is a perspective view illustrating a flow rectifying member according to a second modified example.
Fig. 13 is a top view of the flow rectifying member of Fig. 12.
Fig. 14 is a bottom view of the flow rectifying member of Fig. 12.
Fig. 15 is a diagram illustrating a plasma head according to a third modified example.

### Description of Embodiments

Hereinafter, a plasma head and a plasma generation device will be described with reference to the drawings. In the present embodiment, a case where the plasma generation device is an atmospheric pressure plasma generation device will be described as an example.

### 1. Overall Configuration of Plasma Generation Device 1

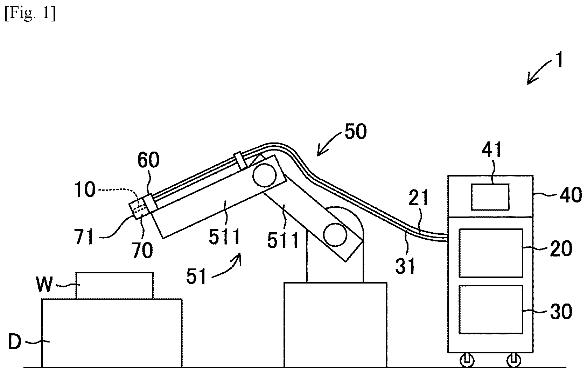

Plasma generation device 1 is a device generating plasma under the atmospheric pressure. As illustrated in Fig. 1, plasma generation device 1 includes plasma head 10, power supply device 20, and gas supply device 30. Plasma generation device 1 supplies power Ph from power supply device 20 to plasma head 10 via power cable 21, and supplies process gas Gs to be converted into plasma from gas supply device 30 via gas pipe 31. As a result, plasma generation device 1 can apply plasma gas Gp from plasma head 10. Plasma generation device 1 includes control device 40 that includes power supply device 20 and gas supply device 30 and that comprehensively controls the operation of plasma generation device 1.

Plasma head 10 is attached to a distal end of robot arm 51 of industrial robot 50. Here, power cable 21 and gas pipe 31 are attached along robot arm 51. Robot arm 51 is an articulated robot in which two arm portions 511 and 511 are connected in one direction. Then, industrial robot 50 drives robot arm 51 to move plasma head 10, and performs work of applying plasma gas Gp to workpiece W supported by workpiece table D. Using applied plasma gas Gp, for example, a modification process of modifying a surface of workpiece W from hydrophobic to hydrophilic can be performed.

Power supply device 20 generates high-frequency AC power to be supplied from, for example, a commercial power supply (not illustrated) to pair of electrodes 12 of plasma head 10 described later. Then, power supply device 20 supplies the generated AC power as power Ph to electrodes 12 of plasma head 10 (more specifically, outer electrode 121 and inner electrode 122) via power cable 21.

Gas supply device 30 supplies, for example, air or the like containing at least one of inert gas such as nitrogen and active gas such as oxygen by pressure-feeding as process gas Gs. Therefore, gas supply device 30 includes a tank (not illustrated) that stores plasma gas Gp. Although omitted in the present embodiment, gas supply device 30 may include a heater for heating process gas Gs supplied to plasma head 10 as necessary. In this case, for example, gas supply device 30 may supply only process gas Gs heated by the heater to plasma head 10, or may mix unheated process gas Gs supplied from the tank and process gas Gs heated by the heater to supply mixed process gas Gs to plasma head 10.

Control device 40 controls operations of power supply device 20, gas supply device 30, and industrial robot 50. In addition, control device 40 includes display section 41. Display section 41 displays various information and the like in plasma generation device 1.

### 2. Plasma Head 10

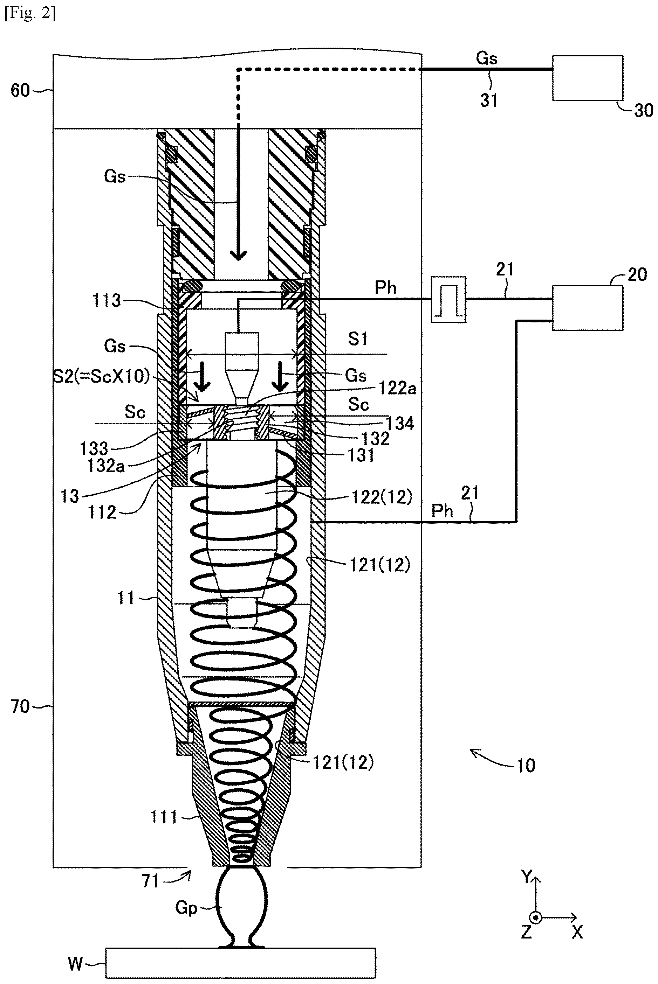

Next, the configuration of plasma head 10 will be described. As illustrated in Fig. 2, a base end side of plasma head 10 is fixed to housing 60, and a distal end side is covered with cover 70. Opening 71 for applying plasma gas Gp generated by plasma head 10 is provided below cover 70.

In the present embodiment, a case where one plasma head 10 is provided is described as an example. However, the number of plasma heads 10 is not limited to one, but multiple plasma heads 10 may be arranged in housing 60. In the following description, as illustrated in Fig. 2, for example, a width direction of housing 60 and cover 70 is an X direction, a height (vertical) direction of housing 60 and cover 70 (that is, an axial direction of plasma head 10 fixed to housing 60) is a Y direction, and a direction orthogonal to the X direction and the Y direction is a Z direction.

Plasma head 10 generates plasma gas Gp by converting process gas Gs into plasma. Then, plasma head 10 applies generated plasma gas Gp to the surface of workpiece W. Plasma gas Gp applied to the surface of workpiece W can perform various surface treatments on the surface of workpiece W, for example, a modification process of modifying the surface of workpiece W from hydrophobicity to hydrophilicity.

Here, a processing capability of plasma gas Gp for performing various surface treatments such as the modification is generally said to have a correlation with a flow velocity of plasma gas Gp reaching a processing position in workpiece W. That is, in order to improve the processing capability of plasma gas Gp, it is necessary to increase the flow velocity of plasma gas Gp applied toward workpiece W. In order to increase the flow velocity of plasma gas Gp, it is necessary to efficiently flow process gas Gs toward the electrodes.

When process gas Gs is converted into plasma, process gas Gs is caused to be made to be a spiral flow to flow between the electrodes as in the above-described conventional device or the like. For this reason, in the conventional device or the like, process gas Gs flows through a hole formed in an inclined manner, thereby being made to be the spiral flow.

In the conventional device or the like, when process gas Gs flows through the hole, a large reduction loss is generated due to large narrowing of a flow path cross-sectional area. As a result, in the conventional device or the like, the flow velocity of process gas Gs flowing between the electrodes decreases, and accordingly, the flow velocity of generated plasma gas Gp applied toward workpiece W also decreases.

In this case, it is conceivable to increase the flow path cross-sectional area by increasing a hole diameter of a hole to be drilled, but due to restrictions imposed on the drilling process, there is a limit to the size of the hole diameter. Accordingly, as in the conventional device or the like, in a case where process gas Gs flows through the hole which is drilled in order to form the spiral flow, a reduction loss, that is, an energy loss caused by narrowing the flow path cross-sectional area when process gas Gs passes through the hole, is large, and it is difficult to increase the flow velocity of plasma gas Gp applied toward workpiece W.

As illustrated in Fig. 2, plasma head 10 of the present embodiment includes cylindrical main body 11 which conducts process gas Gs to be converted into plasma, pair of electrodes 12 which are accommodated in main body 11 and discharge a part of process gas Gs to generate plasma gas Gp, and flow rectifying member 13 which has multiple flow rectifying plates 131, which make process gas Gs introduced into main body 11 form the spiral flow and supply process gas Gs to electrodes 12.

Main body 11 is made of, for example, conductive metal. Conical nozzle 111 is mounted on the distal end side of main body 11 in the axial direction. Nozzle 111 applies plasma gas Gp generated by converting process gas Gs into plasma to workpiece W. Gas pipe 31 is airtightly connected to the base end side of main body 11 in the axial direction, and process gas Gs is pressure-fed and supplied from gas supply device 30 via gas pipe 31. In the present embodiment, main body 11 and nozzle 111 function as outer electrode 121 of pair of electrodes 12.

As described above, pair of electrodes 12 include outer electrode 121 formed by main body 11 and nozzle 111, and inner electrode 122 accommodated in main body 11 and disposed on a center side of main body 11. Then, by discharging process gas Gs supplied between outer electrode 121 and inner electrode 122, process gas Gs is converted into plasma to generate plasma gas Gp. Instead of forming outer electrode 121 by main body 11 and nozzle 111, for example, outer electrode 121 may be separately formed on inner peripheral surfaces of main body 11 and nozzle 111. In this case, main body 11 and nozzle 111 need not be formed of conductive metal.

Here, power supply device 20 is connected to each of outer electrode 121 and inner electrode 122 via power cable 21. Thus, power Ph, which is high-frequency AC power, is supplied to outer electrode 121 and inner electrode 122, and a voltage is applied thereto. In the present embodiment, inner electrode 122 is supported by flow rectifying member 13 fixed inside main body 11 as described later.

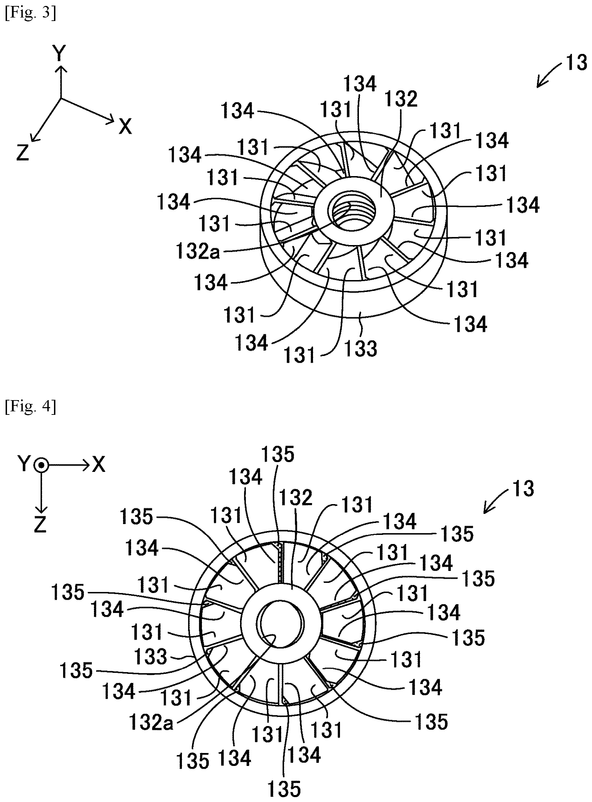

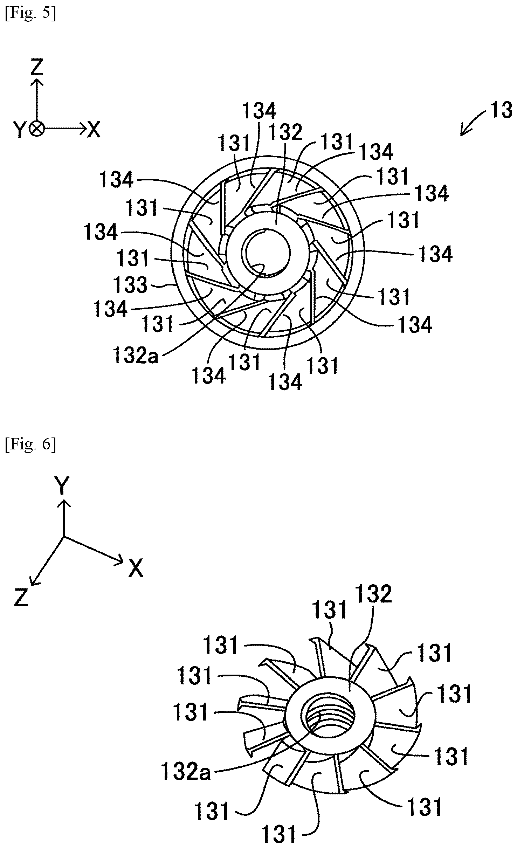

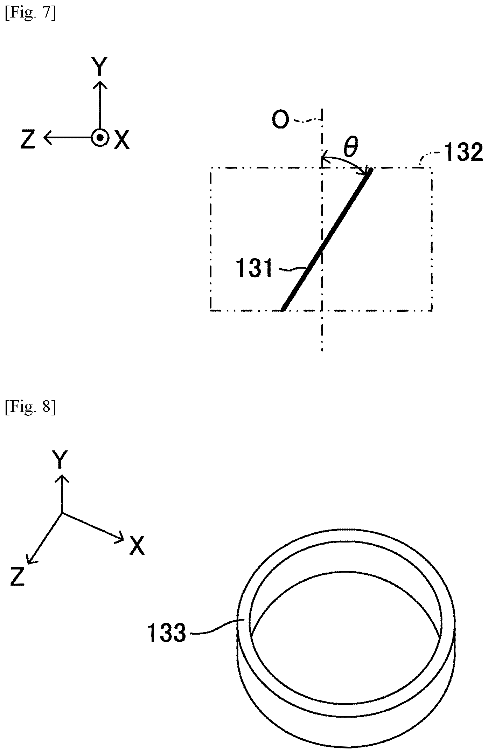

As illustrated in Figs. 3 to 5, flow rectifying member 13 of the present embodiment has a circular plate shape and includes flow rectifying plate 131, first circular ring 132, and second circular ring 133. As illustrated in Fig. 6, flow rectifying plate 131 is formed using a thin plate, and a first end thereof is fixed to an outer peripheral surface of first circular ring 132. As illustrated in Fig. 7, flow rectifying plate 131 is disposed in a helical tooth shape which is disposed obliquely to have inclination angle θ with respect to axis O of first circular ring 132.

As illustrated in Fig. 6, first circular ring 132 has female screw portion 132a on an inner peripheral surface thereof, and flow rectifying plates 131 are fixed at equal intervals along a circumferential direction of the outer peripheral surface thereof. As illustrated in Fig. 2, female screw portion 132a is screwed with male screw portion 122a provided on inner electrode 122. Thus, first circular ring 132 supports inner electrode 122, which is one of pair of electrodes 12, disposed on the center side of main body 11.

As illustrated in Fig. 8, second circular ring 133 is formed larger in diameter than first circular ring 132. Second circular ring 133 is disposed concentrically with first circular ring 132, and supports a second end of flow rectifying plate 131 in a radial outer direction of first circular ring 132. Flow rectifying plate 131 having the first end fixed to first circular ring 132 is assembled, for example, by being press-fitted to the inner periphery of second circular ring 133. As a result, as illustrated in Figs. 3 to 5, flow rectifying member 13 of the present embodiment has ten flow paths 134 partitioned by an outer peripheral surface of first circular ring 132, flow rectifying plate 131 fixed to have inclination angle θ, and an inner peripheral surface of second circular ring 133.

As illustrated in Fig. 2, second circular ring 133 is sandwiched and fixed by support member 112 and holding member 113 accommodated in main body 11. As a result, flow rectifying plate 131 and first circular ring 132 assembled to second circular ring 133 are fixed to main body 11, and inner electrode 122 with male screw portion 122a screwed to female screw portion 132a of first circular ring 132 is fixed to main body 11.

Here, a case where flow rectifying member 13 makes process gas Gs form the spiral flow will be described with reference to Fig. 2. In plasma head 10, process gas Gs is pressure-fed and supplied from gas supply device 30 to the upstream side (upper side in the Y direction in Fig. 2) of flow rectifying member 13. When process gas Gs is supplied, process gas Gs flows toward the downstream side of flow rectifying member 13 (downward in the Y direction in Fig. 2) via ten flow paths 134 formed in flow rectifying member 13.

As described above, in flow rectifying member 13, flow rectifying plate 131 is disposed to be inclined by inclination angle θ with respect to axis O. Therefore, process gas Gs having passed through flow path 134 is made to be the spiral flow on the downstream side of flow rectifying member 13, that is, between outer electrode 121 and inner electrode 122, and flows toward nozzle 111. At this time, process gas Gs being made to be the spiral flow flows while coming into contact with outer electrode 121 and inner electrode 122, and outer electrode 121 and inner electrode 122 are discharged. Accordingly, at least a part of process gas Gs is converted into plasma, and plasma gas Gp is applied from nozzle 111.

In order to suppress a decrease in the flow velocity of plasma gas Gp, it is necessary to reduce a reduction loss when process gas Gs passes through flow rectifying member 13 to maintain the flow velocity. Therefore, in flow rectifying member 13 of the present embodiment, for example, flow rectifying plate 131 is disposed to satisfy three conditions described below.

First, as illustrated in Fig. 2, the flow path cross-sectional area when process gas Gs pressure-fed from gas supply device 30 passes through the inside of main body 11 is defined as first flow path cross-sectional area S1. Further, as illustrated in Fig. 2, the flow path cross-sectional area obtained by totaling flow path cross-sectional areas Sc of respective flow paths 134 formed by flow rectifying plate 131 is defined as second flow path cross-sectional area S2 (= Sc × 10).

In flow rectifying member 13 of the present embodiment, flow rectifying plate 131 is disposed such that flow path cross-sectional area ratio R (= S2 / S1) of second flow path cross-sectional area S2 with respect to first flow path cross-sectional area S1 is 0.8 or more. In addition, since flow path cross-sectional area ratio R is set to 0.8 or more, in flow rectifying member 13 of the present embodiment, loss coefficient Ks which represents a reduction loss generated when process gas Gs passes through flow paths 134 that change from first flow path cross-sectional area S1 to second flow path cross-sectional area S2 is 0.1 or less. In addition, since flow path cross-sectional area ratio R is set to 0.8 or more, in flow rectifying member 13 of the present embodiment, contraction coefficient Kh associated with the reduction loss generated when process gas Gs passes through flow paths 134 that change from first flow path cross-sectional area S1 to second flow path cross-sectional area S2 is 0.7 or more.

That is, since flow rectifying member 13 can form flow path 134 through which process gas Gs flows by using thin flow rectifying plate 131, for example, narrowing of flow path 134 can be reduced than in a case where a hole formed by drilling is used as the flow path. In other words, in the case where flow rectifying member 13 is used, since the processing restriction is reduced, the resistance generated when process gas Gs is made to be the spiral flow can be made smaller than the resistance generated in a case where process gas Gs is made to be a spiral flow using the hole formed by drilling.

That is, by using flow rectifying member 13 in plasma head 10, process gas Gs can be smoothly made to be the spiral flow, and process gas Gs can be caused to flow toward electrodes 12 while suppressing a decrease in the flow velocity. As a result, it is possible to suppress a decrease in the flow velocity of plasma gas Gp generated due to the passage between electrodes 12, and to apply plasma gas Gp to workpiece W from nozzle 111.

Here, flow rectifying member 13 of the present embodiment is set to, for example, 5° to 55°, more preferably 10° to 50°, and still more preferably 15° to 45°, as the size of inclination angle θ to satisfy the above-described conditions, when flow rectifying plate 131 is disposed.

Further, as illustrated in Fig. 4, it is assumed of a case where flow rectifying member 13 having flow rectifying plate 131 disposed in a helical tooth shape on the outer peripheral surface of first circular ring 132 is viewed from the side on which process gas Gs is supplied to flow rectifying member 13 (that is, on the upstream side of flow rectifying member 13, for example, above in the Y direction in Fig. 2) in the direction of axis O of first circular ring 132 (Y direction). In this case, in a case of assuming that flow rectifying plate 131 is not provided on the outer peripheral surface of first circular ring 132, the occupied area of flow rectifying plate 131 disposed in the helical tooth shape is 90% or more of the annular flow path cross-sectional area through which process gas Gs passes formed by the outer peripheral surface of first circular ring 132 and the inner peripheral surface of second circular ring 133.

That is, in flow rectifying member 13 having flow rectifying plate 131 disposed in the helical tooth shape, the flow path cross-sectional area of linear flow path 135 (indicated by a dot pattern (dark color) in Fig. 4) along axis O direction (Y direction) of first circular ring 132 is less than 10%. Accordingly, when process gas Gs passes through flow rectifying member 13, since most of process gas Gs comes into contact with flow rectifying plate 131 disposed in the helical tooth shape, the spiral flow can be generated in process gas Gs.

As can be understood from the above description, plasma head 10 includes cylindrical main body 11 which conducts process gas Gs to be converted into plasma, pair of electrodes 12 (outer electrode 121 and inner electrode 122) which are accommodated in main body 11 and discharge a part of process gas Gs to generate plasma gas Gp, and flow rectifying member 13 which has multiple flow rectifying plates 131 which make process gas Gs introduced into main body 11 and supplied to pair of electrodes 12 (outer electrode 121 and inner electrode 122) form the spiral flow.

With plasma head 10, the spiral flow can be generated by flowing process gas Gs through flow rectifying member 13 having flow path 134 formed by flow rectifying plate 131. In this way, by partitioning flow path 134 by using thin flow rectifying plate 131, it is possible to increase flow path cross-sectional area Sc of each of flow paths 134 through which process gas Gs flows, as compared with the case where the hole is drilled.

Accordingly, it is possible to reduce the reduction loss when process gas Gs flows through flow rectifying member 13, and thus it is possible to suppress a decrease in the flow velocity of process gas Gs supplied to pair of electrodes 12. As a result, the flow velocity of generated plasma gas Gp is suppressed from decreasing, and the flow velocity of plasma gas Gp applied toward workpiece W can be increased. Accordingly, in plasma head 10, in other words, plasma generation device 1, the processing capability of plasma gas Gp to be applied can be improved.

### 3. First Modified Example

In the above-described embodiment, the size of inclination angle θ of flow rectifying plate 131 in flow rectifying member 13 is relatively small (that is, flow rectifying plate 131 is on a side parallel to axis O, so to speak, flow rectifying plate 131 is in a state of being upright). For example, when various surface treatments are performed on workpiece W, the generation amount of plasma gas Gp may be increased according to the process content. In this case, the size of inclination angle θ of flow rectifying plate 131 can be set to be large (that is, flow rectifying plate 131 is on a side angled with respect to axis O, so to speak, flow rectifying plate 131 is in a state of being laid down).

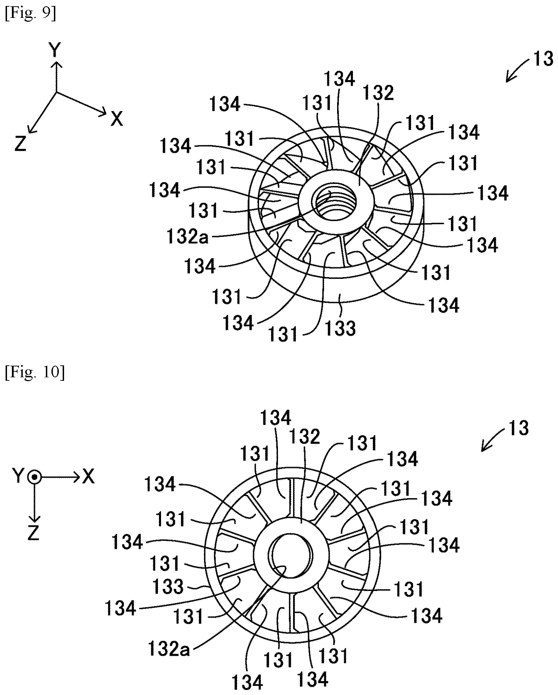

Figs. 9 to 11 illustrate a case where inclination angle θ of flow rectifying plate 131 with respect to axis O of first circular ring 132 is large as compared with the case of Figs. 3 to 5 described above, so to speak, flow rectifying plate 131 is laid down. In this case, as compared with the case of the above-described embodiment, since flow rectifying plate 131 is laid down, flow path cross-sectional area Sc of each of flow paths 134 becomes small and the reduction loss becomes large, but a strong spiral flow can be generated by process gas Gs passing through. That is, in this case, since process gas Gs is accompanied by the strong spiral flow, the number of revolutions (revolution number) of process gas Gs until process gas Gs is applied from nozzle 111 is increased. Therefore, in this case, since the distance in which process gas Gs comes into contact with outer electrode 121 and inner electrode 122 becomes long, the ratio of process gas Gs to be converted into plasma, in other words, the amount of generation of plasma gas Gp, can be increased.

### 4. Second Modified Example

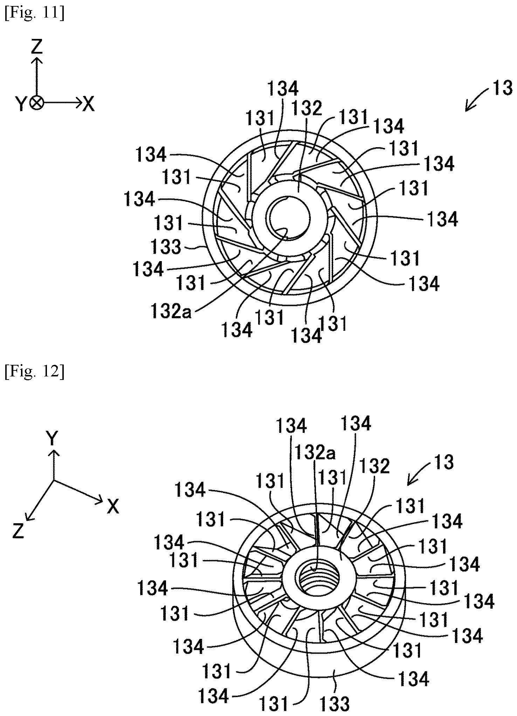

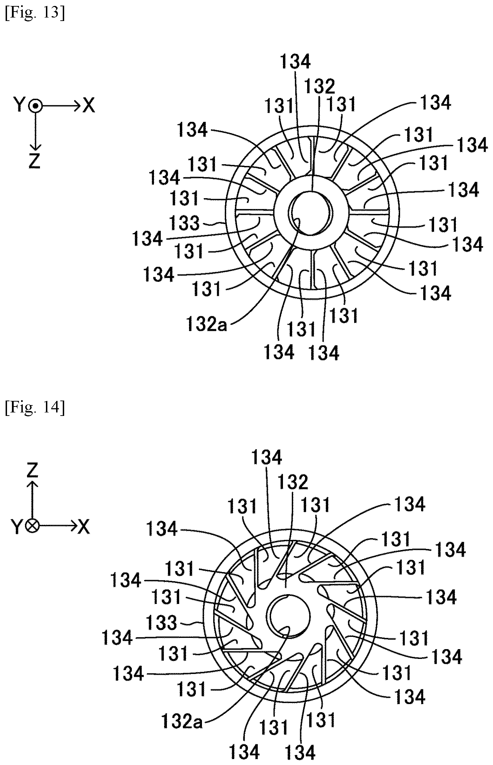

In the embodiment and the first modified example described above, the number of flow rectifying plates 131 in flow rectifying member 13, that is, the number of flow paths 134 in flow rectifying member 13, is 10. However, the number of flow rectifying plates 131, that is, the number of flow paths 134 in flow rectifying member 13, is not limited to 10, and may be increased to 12, for example, as illustrated in Figs. 12 to 15. In flow rectifying member 13, in a case where the number of flow paths 134 is increased, flow path cross-sectional area Sc of each of flow paths 134 is relatively small, but since second flow path cross-sectional area S2 does not change, the reduction loss does not change either.

However, as the number of flow paths 134 increases, the resistance acting on process gas Gs when passing through flow path 134 becomes relatively large, and as a result, a decrease in the flow velocity of process gas Gs may occur. Accordingly, in order to compensate for a decrease in the flow velocity of process gas Gs, that is, a decrease in the flow velocity of plasma gas Gp, for example, the size of inclination angle θ is increased (that is, flow rectifying plate 131 is laid down), the number of revolutions of process gas Gs is increased as described above, and the amount of generation of plasma gas Gp is increased. This makes it possible to compensate for a reduction in the processing capability of plasma gas Gp.

Alternatively, the number of flow rectifying plates 131, that is, the number of flow paths 134 in flow rectifying member 13, may be reduced from ten, although not illustrated. In flow rectifying member 13, in a case where the number of flow rectifying plates 131, that is, flow paths 134, is reduced, flow path cross-sectional area Sc of each of flow paths 134 can be relatively large. However, in flow rectifying member 13, in a case where the number of flow rectifying plates 131, that is, flow paths 134, is reduced, particularly when inclination angle θ is small, it may be difficult to generate a sufficient spiral flow in process gas Gs. Accordingly, in a case where a strong spiral flow is generated in flow rectifying member 13, as described above, it is necessary to relatively increase inclination angle θ of flow rectifying plate 131, and as a result, the reduction loss may be relatively large.

Based on this, in a case of considering the balance between the size of the reduction loss and the strength (the number of revolutions) of the spiral flow of process gas Gs, the number of flow rectifying plates 131 may be set to, for example, 6 or more and 14 or less, more preferably 7 or more and 13 or less, and still more preferably 8 or more and 12 or less. By setting the number of flow rectifying plates 131 in this way, flow path cross-sectional area ratio R of 0.8 or more can be maintained, loss coefficient Ks can be set to 0.1 or less, and contraction coefficient Kh can be set to 0.7 or more.

### 5. Third Modified Example

In the above-described embodiment and each modified example, the case where flow rectifying member 13 has second circular ring 133, that is, the second end of flow rectifying plate 131 is supported by second circular ring 133, has been described as an example. However, second circular ring 133 of flow rectifying member 13 may be omitted as necessary.

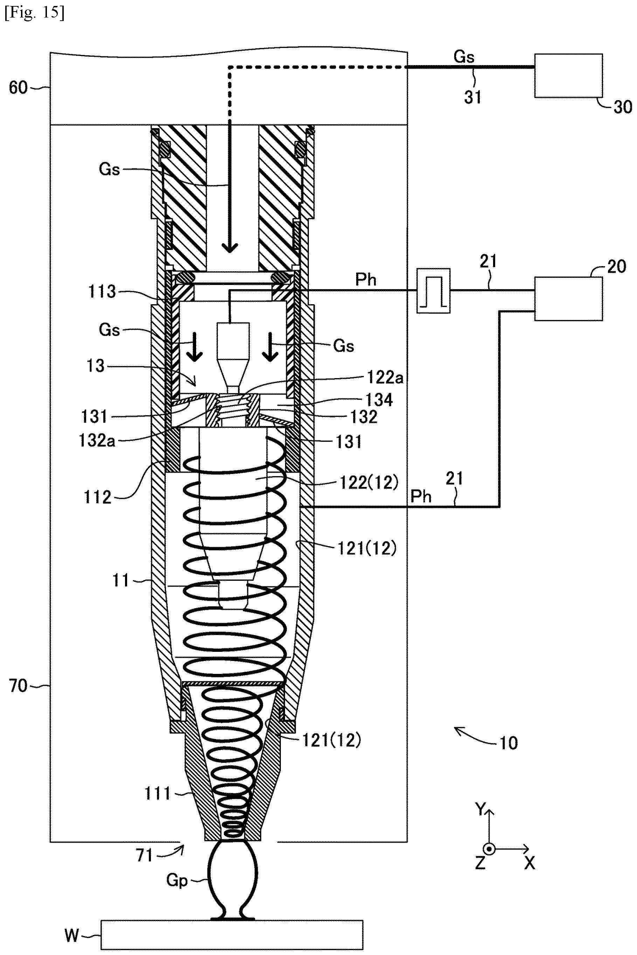

In a case where second circular ring 133 of flow rectifying member 13 is omitted, as illustrated in Fig. 15, for example, since flow rectifying plate 131 is sandwiched by support member 112 and holding member 113 accommodated in main body 11, flow rectifying member 13 can be fixed to main body 11. Further, since flow rectifying member 13 is fixed to main body 11, male screw portion 122a of inner electrode 122 can be screwed into female screw portion 132a of first circular ring 132 to fix inner electrode 122. In this case, flow path 134 is formed by the outer peripheral surface of first circular ring 132 of flow rectifying member 13, flow rectifying plate 131, and the inner peripheral surface of main body 11. Therefore, even in this case, the same effects as those of the above-described embodiment can be obtained.

### 6. Fourth Modified Example

In the above-described embodiment, the first modified example, and the second modified example, flow rectifying member 13 is formed by assembling the integrated body of flow rectifying plate 131 and first circular ring 132 to second circular ring 133. That is, in above-described flow rectifying member 13, second circular ring 133 is handled as a separate body. However, instead of this, for example, it is also possible to manufacture flow rectifying member 13 having a complicated shape by integrally forming flow rectifying plate 131, first circular ring 132, and second circular ring 133 using a well-known additive manufacturing technique. In this case, the operation of separately assembling flow rectifying member 13 can be omitted.

### Reference Signs List

1: plasma generation device, 10: plasma head, 11: main body, 111: nozzle, 112: support member, 113: holding member, 12: electrode, 121: outer electrode, 122: inner electrode, 122a: male screw portion, 13: flow rectifying member, 131: flow rectifying plate, 132: first circular ring, 132a: female screw portion, 133: second circular ring, 134: flow path, 135: flow path, 20: power supply device, 21: power cable, 30: gas supply device, 31: gas pipe, 40: control device, 41: display section, 50: industrial robot, 51: robot arm, 511: arm portion, 60: housing, 70: cover, 71: opening, Gs: process gas, Gp: plasma gas, θ: inclination angle, O: axis, S1: first flow path cross-sectional area, S2: second flow path cross-sectional area, Sc: flow path cross-sectional area, R: flow path cross-sectional area ratio, Ks: loss coefficient, Kh: contraction coefficient, Ph: power (AC power), W: workpiece, D: workpiece table

## Claims

1. A plasma head comprising:
a cylindrical main body configured to conduct a process gas to be converted into plasma;
a pair of electrodes accommodated in the main body and configured to discharge a part of the process gas to generate a plasma gas; and
a flow rectifying member having multiple flow rectifying plates configured to make the process gas introduced into the main body and supplied to the pair of electrodes form a spiral flow.

2. The plasma head according to Claim 1, wherein the flow rectifying member has
a first circular ring configured to support one of the pair of electrodes disposed on a center side of the main body, and
the flow rectifying plate which has a first end fixed to an outer peripheral surface of the first circular ring and which is disposed in a helical tooth shape inclined with respect to an axis of the first circular ring.

3. The plasma head according to Claim 2, wherein the flow rectifying member has a second circular ring disposed concentrically with the first circular ring and configured to support a second end of the flow rectifying plate in a radial outer direction of the first circular ring.

4. The plasma head according to Claim 2 or 3, wherein, when the flow rectifying member is viewed from a side on which the process gas is supplied to the flow rectifying member in a direction of the axis of the first circular ring,
an occupied area of the flow rectifying plate is 90% or more of an annular flow path cross-sectional area through which the process gas passes when it is assumed that the flow rectifying plate is not provided on the outer peripheral surface of the first circular ring.

5. The plasma head according to Claim 2 or 3, wherein in the flow rectifying member, the flow rectifying plate is disposed such that a flow path cross-sectional area ratio of a second flow path cross-sectional area that is obtained by totaling flow path cross-sectional areas of flow paths which are formed by the flow rectifying plate and through which the process gas passes, with respect to a first flow path cross-sectional area in which the process gas passes through an inside of the main body, is 0.8 or more.

6. The plasma head according to Claim 5, wherein in the flow rectifying member, a loss coefficient representing a reduction loss occurring when the process gas passes through the flow paths that change from the first flow path cross-sectional area to the second flow path cross-sectional area is 0.1 or less.

7. The plasma head according to Claim 5, wherein in the flow rectifying member, a contraction coefficient associated with a reduction loss occurring when the process gas passes through the flow paths that change from the first flow path cross-sectional area to the second flow path cross-sectional area is 0.7 or more.

8. The plasma head according to any one of Claims 1 to 3, wherein the number of the flow rectifying plates that the flow rectifying member comprises is 6 or more and 14 or less.

9. A plasma generation device comprising:
the plasma head according to any one of Claims 1 to 3;
a power supply device configured to supply power to the electrode; and
a gas supply device configured to supply the process gas to the main body.

10. The plasma generation device according to Claim 9, wherein the power supply device supplies high-frequency AC power to the electrode.
